(19) Europäisches Patentamt
European Patent Office
Office européen des brevets

(11) **EP 4 009 066 A1**

(12) **EUROPEAN PATENT APPLICATION**

(43) Date of publication:
08.06.2022 Bulletin 2022/23

(21) Application number: 20212205.7

(22) Date of filing: 07.12.2020

(51) International Patent Classification (IPC):
*G01R 33/385* (2006.01)   *G01R 33/48* (2006.01)
*G01R 33/54* (2006.01)   *G01R 33/483* (2006.01)
*G01R 33/561* (2006.01)

(52) Cooperative Patent Classification (CPC):
**G01R 33/385; G01R 33/3852; G01R 33/4818;
G01R 33/4833; G01R 33/543;** G01R 33/5614;
G01R 33/5616

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Healthcare GmbH**
**91052 Erlangen (DE)**

(72) Inventors:
• **Bhat, Himanshu**
 **Newton, MA 02459 (US)**
• **Giese, Daniel**
 **51052 Erlangen (DE)**
• **Grodzki, David**
 **91058 Erlangen (DE)**
• **Majeed, Waqas**
 **Ellicott City, MD 21043 (US)**
• **Speier, Peter**
 **91056 Erlangen (DE)**

(54) **MAGNETIC RESONANCE IMAGING WITH IMPROVED GRADIENT USAGE**

(57)    According to a method for operating an MRI system (1), an orientation of a logical coordinate system (R, P, S) and a first limit value concerning components of a magnetic field gradient in a coil coordinate system (X, Y, Z) are received. A second limit value concerning respective components of the magnetic field gradient in a logical coordinate system (R, P, S) is determined depending on the orientation and the first limit value. A gradient sequence for the logical coordinate system (R, P, S) is determined depending on the second limit value to implement a k-space sampling scheme. The MRI system (1) is controlled to carry out an MRI scan according to the k-space sampling scheme and the gradient sequence.

FIG 3

**Description**

The present invention is directed to a method for operating a magnetic resonance imaging system comprising gradient coils for generating respecting components of a magnetic field gradient along respective coordinate axes of a coil coordinate system. The invention further relates to a corresponding magnetic resonance imaging system and to a computer program product.

In magnetic resonance imaging, MRI, an object to be imaged is placed into a strong external magnetic field to align its nuclear spins. An alternating magnetic field is applied to excite the nuclear spins to precess. The precession of the nuclear spins and, in particular, the returning of the nuclear spins from the excited state into a state with lower energy generates an answer signal in form of an alternating magnetic field, which may be received via respective antennas.

By means of magnetic field gradients, the signals are spatially encoded to allow for a correlation of the received signal to a volume element of the object to be imaged. The received signal is then evaluated to obtain a spatial representation of the object.

In order to achieve a high spatial and temporal resolution while minimizing scan time and off-resonance artifacts, the magnetic field gradients are usually tuned to allow for short timing parameters, such as echo time TE and repetition time TR. The magnetic field gradients of an MRI sequence is defined in a logical coordinate system, usually denoted as read-axis, phase-axis and slice-axis. The axes of the logical coordinate system do, however, in general not coincide with the physical coordinate axes of the MRI system of or, in other words, to the axes along which the magnetic field gradients are generated by means of the gradient coils. The physical coordinate axes and the physical coordinate system are therefore also denoted as coil coordinate axes and coil coordinate system, respectively.

On the other hand, physical limitations, for example due to maximum currents that may be applied to the gradient coils, are given according to the coil coordinate system rather than according to the logical coordinate system. Furthermore, the orientation of the logical coordinate system is not fixed but may be adapted during the imaging procedure or between different MRI scans.

Depending on the orientation of the logical coordinate system, gradients of different logical axes may overlap on a single coil axis. In this case, the physical constraints of the respective coil axis have to be accounted for. As a consequence, the maximum possible gradient values on the individual coil axes are in general not exploited to avoid an overload in worst case situations regarding the orientation of the logical coordinate system with respect to the coil coordinate system.

It is therefore in general desirable to optimize the gradient usage during MRI. To this end, document US 2020/0064426 A1 describes systems and methods for waveform optimization for oblique scans. In one embodiment, initial gradient waveforms are generated according to logical axes and an area demand of each of the initial gradient waveforms is evaluated. In other words, it is exploited that the main requirement is to realize the required zeroth moment of the magnetic field gradients, that is the area under the gradient pulses, while the actual gradient pulse shape is of less importance.

It is therefore an object of the present invention, to provide an improved concept for magnetic resonance imaging, which further optimizes magnetic field gradient usage.

This object is achieved by the respective subject-matter of the independent claims. Preferred embodiments and further implementations are subject-matter of the dependent claims.

The improved concept is based on the idea to explicitly take into account the orientation of the logical coordinate system with respect to the coil coordinate system to define corresponding limit values for magnetic field gradient components.

According to the improved concept, a method for operating a magnetic resonance imaging, MRI, system is provided. The MRI system comprises gradient coils for generating respective components of a magnetic field gradient along respective coordinate axes of a coil coordinate system of the gradient coils. The method comprises using a computing unit, in particular of the MRI system, to receive an orientation of a predefined logical coordinate system with respect to the coil coordinate system, in particular from a user input interface or from a storage unit of the MRI system. The computing unit is used to receive at least one predefined first limit value concerning the components of the magnetic field gradient in the coil coordinate system, in particular from the storage unit. The computing unit is used to determine, in particular automatically, at least one second limit value concerning respecting components of the magnetic field gradient in the logical coordinate system depending on the orientation and on the at least one first limit value. The computing unit is used to determine, in particular automatically, a gradient sequence for the components of the magnetic field gradient in the logical coordinate system depending on the at least one second limit value to implement a predefined k-space sampling scheme. The computing unit is used to control the MRI system to carry out an MRI scan according to the k-space sampling scheme, wherein the gradient coils are controlled to carry out the gradient sequence.

The coil coordinate system and the logical coordinate system are, in particular, three-dimensional Cartesian coordinate systems. Consequently, the gradient coils of the MRI system comprise one or more coils for each of the three axes of the coil coordinate system. The axes of the coil coordinate system may be denoted as X-, Y- and Z-axis, respectively. Consequently, the gradient coils may be denoted as X-coils, Y-coils and Z-coils, wherein the one or more X-coils are arranged to generate an X-component of the magnetic field gradient along the X-axis, the one or more Y-coils are arranged to generate a respective Y-component of the magnetic field gradient along the Y-axis and the one or more Z-coils are arranged to generate a Z-component of the magnetic field gradient along the Z-component.

The at least one first limit value concerning the components of the magnetic field gradient in the coil coordinate system comprises, for example, at least one first limit value for the X-axis or the X-coils, respectively, at least one first limit value for the Y-axis or the Y-coils, respectively, and at least one first limit value for the Z-axis or the Z-coils, respectively. Analogously, the at least one second limit value concerning respective components of the magnetic field gradient in the logical coordinate system may for example comprise at least one second limit value for the read-axis, at least one second limit value for the phase-axis and at least one second limit value for the slice-axis.

The at least one first limit value for the X-, Y- and Z-axis, respectively, may comprise a first limit value for an amplitude of the respective component of the magnetic field gradient and/or a first limit value for a slew rate of the respective component of the magnetic field gradient. Therein, the first limit values for the amplitude for different axes may be identical or differ from each other. Analogously, the at least one second limit value for the read-, phase- and slice-axis, respectively, may comprise a second limit value for the amplitude of the respective component of the magnetic field gradient and/or a second limit value for the slew rate of the respective component of the magnetic field gradient. Therein, the second limit values for the amplitude for different axes may be identical or differ from each other

The orientation of the logical coordinate system with respect to the coil coordinate system may for example be provided as a rotation matrix, which maps the logical coordinate system to the coil coordinate system or vice versa. Alternatively, the orientation may be given by an equivalent set of data, such as rotation angles, Euler angles, et cetera.

The MRI scan may be considered to comprise the gradient sequence and a corresponding radio-frequency, RF, pulse sequence for exciting or manipulating the nuclear spins of an object to be imaged. In order to carry out the gradient sequence, the gradient coils may be controlled to generate a respective time dependent magnetic field gradient according to the gradient sequence.

In addition, for controlling the MRI system to carry out the MRI scan, one or more sending antennas or sending coils, one or more receiving antennas or receiving coils and corresponding equipment may be controlled.

By taking into account the orientation of the logical coordinate system with respect to the coil coordinate system explicitly for determining the second limit values and, consequently, the gradient sequence, the constraints on the magnetic field gradient, in particular in terms of the absolute value of the gradient pulses and the slew rate of the gradient pulses, may be exploited optimally for each orientation or slice angulation, respectively.

In particular, for different orientations, the gradients on the individual logical axes require different contributions from the different coordinate axis or gradient coils, respectively. Therefore, instead of assuming a worst-case situation corresponding to a maximum overlap of all three logical axes on one coordinate axis, the actual situation and therefore the actual constraints are considered. In other words, safety margins for the absolute value of the gradient components in the coil coordinate system as well as the slew rates of the components in the coil coordinate system may be relaxed. Since they are adapted according to the orientation they are, in general, smaller than for the worst-case scenario.

In this way, the MRI sequence may make use of the highest acceptable absolute values for the magnetic field gradients and the highest acceptable slew rates for the gradient coils. As a consequence, timing parameters of the MRI sequence, such as echo time TE and repetition time TR, may be optimized in order to obtain a shorter total acquisition time.

In particular, the improved concept allows for a real-time interactive sequence, wherein a user of the MRI system is allowed to make modifications to the slice orientation and, in consequence, to the orientation of the logical coordinate system online.

According to several implementations of the method according to the improved concept, the at least one first limit value comprises a first maximum absolute value for an amplitude of the components of the magnetic field gradient in the coil coordinate system. The at least one second limit value comprises a second maximum absolute value for the amplitude of the components of the magnetic field gradient in the logical coordinate system.

In particular, the first maximum absolute value for the amplitude may correspond to a respective maximum value for each of the components of the magnetic field gradient in the coil coordinate system. In other words, the first maximum absolute value for the amplitude is the same for all three coil axes. Analogously, the second maximum absolute value for the amplitude may correspond to a common maximum absolute value for the amplitude for all three logical axes. In alternative implementations, the individual coil axes and/or the individual logical axes may have different maximum absolute values for the amplitude, respectively.

In this way, the amplitude of the gradient components in the logical coordinate systems may be chosen in an optimized way, in particular they may be chosen as large as possible for the underlying constraints given by the first maximum absolute value for the amplitude in the coil coordinate system.

According to several implementations, the at least one first limit value comprises a first maximum absolute value for a slew rate of the components of the magnetic field gradient in the coil coordinate system. The at least one second limit value comprises a second maximum absolute value for a slew rate of the components of the magnetic field gradient in the logical coordinate system.

In particular, the first maximum absolute value for the slew rate may correspond to a respective maximum value for each of the components of the magnetic field gradient in the coil coordinate system. In other words, the first maximum absolute value for the slew rate is the same for all three coil axes. Analogously, the second maximum absolute value for the slew rate may correspond to a common maximum absolute value for the slew rate for all three logical axes. In alternative implementations, the individual coil axes and/or the individual logical axes may have different maximum absolute values for the slew rate, respectively.

In this way, the slew rate of the gradient components in the logical coordinate systems may be chosen in an optimized way, in particular they may be chosen as large as possible for the underlying constraints given by the first maximum absolute value for the slew rate in the coil coordinate system.

According to several implementations, the computing unit is used to receive at least on boundary condition for the gradient sequence, in particular from the storage unit. The at least one second limit value is determined, in particular automatically by the computing unit, depending on the at least one boundary condition.

In this way, it may be exploited that the different components of the magnetic field gradient are not necessarily uncorrelated or independent of each other. For example, the at least one boundary condition may correlate absolute values and/or polarities of different components of the magnetic field gradient in the logical coordinate system to each other. This additional information may be used to further reduce the limitations imposed by the at least one second limit value.

According to several implementations, the at least one boundary condition comprises at least one predefined correlation between the components of the magnetic field gradient in the logical coordinate system.

According to several implementations, the at least one boundary condition comprises at least one predefined correlation between respective polarities of the components of the magnetic field gradient in the logical coordinate system and/or at least one predefined correlation between respective absolute values of amplitudes of the magnetic field gradient in the logical coordinate system.

For example, absolute value and/or slew rate may be known to be smaller by at least a predefined factor for the phase-axis compared to the read-axis or vice versa. Then, this information may be used to obtain the highest possible at least one second limit value.

For example, it may be predefined that read and slice gradient amplitudes and slew rates only have non-opposing polarities during the whole MRI scan or, in other situations, have only non-identical polarities during the whole MRI scan. In both cases or in other comparable cases, this information may be used to optimize or maximize the amplitudes or slew rates and, in particular, the at least one second limit value.

According to several implementations, the orientation of the logical coordinate system with respect to the coil coordinate system is given by a set of rotation parameters, and the at least one second limit value is determined depending on the set of rotation parameters.

The rotation parameters may for example be given in the form of rotation matrix or in the form of a set of rotation angles, such as Euler angles or the like.

The set of rotation parameters may be directly used to optimize the at least one second limit value including, if applicable, the respective boundary condition for the gradient sequence.

According to several implementations, at least one timing parameter of the MRI scan is minimized for determining the gradient sequence, in particular by the computing unit, wherein the at least one second limit value is used as at least one minimization boundary condition.

In particular, for minimizing the at least one timing parameter, the computing unit may determine the largest possible absolute values and/or slew rates for the individual components of the magnetic field gradient in the logical coordinate system, which still comply with the minimization boundary condition given by the at least one second limit value. For the sake of clarity, it is noted that the at least one minimization boundary condition does not correspond to the at least one boundary condition for the gradient sequence.

By minimizing the at least one timing parameter, the total acquisition time of the MRI scan may be reduced.

According to several implementations, the at least one timing parameter comprises an echo time TE and/or a repetition time TR.

According to several implementations, the logical coordinate system comprises the read-axis and the read-axis corresponds to a frequency encoded spatial direction. According to several implementations, the logical coordinate system comprises the phase-axis and the phase-axis corresponds to a phase encoded spatial direction. According to several implementations, the logical coordinate system comprises a slice-axis and the slice-axis corresponds to a spatial direction, which is perpendicular to a slice to be imaged.

In particular, also the slice-axis may correspond to a frequency encoded direction or, in other words, the spatial direction, which is perpendicular to the slice of the object to be imaged may correspond to a frequency encoded spatial direction.

According to several implementations, the computing unit is used to compute a modified orientation of a modified logical coordinate system, wherein a direction of a modified coordinate axis of the modified logical coordinate system is opposite to a direction of a coordinate axis of the predefined logical coordinate system. The at least one second limit value is determined depending on the modified orientation.

In particular, the predefined logical coordinate system is identical to the modified logical coordinate system except for the direction of the modified coordinate axis.

In other words, if the logical coordinate system is given by the three unit vectors (r, p, s), the modified logical coordinate system is given by the three unit vectors (-r, p, s) or (r, -p, s) or (r, p, -s).

According to several implementations, the computing unit is used to compute a modified orientation of a modified logical coordinate system, wherein respective directions of two modified coordinate axes of the modified logical coordinate system are opposite to respective directions of two coordinate axes of the logical coordinate system. The at least one second limit value is determined depending on the modified orientation.

In particular, the predefined logical coordinate system is identical to the modified logical coordinate system except for the direction of the two modified coordinate axes.

In other words, if the logical coordinate system is given by the three unit vectors (r, p, s), the modified logical coordinate system is given by the three unit vectors (-r, -p, s) or (-r, p, -s) or (r, -p, -s).

By inverting the modified axes compared to the respective axes of the logical coordinate system, the gradient activity of one of the coordinate axes may be significantly reduced, which in turn allows for an overall more efficient planning of the gradient sequence.

According to several implementations, the gradient sequence is determined as a gradient sequence for a gradient echo, GRE, pulse sequence or as a gradient sequence for a balanced steady-state free precession, bSSFP, pulse sequence.

Although the improved concept is applicable to arbitrary gradient sequences, it may be particularly beneficial for GRE or bSSFP sequences.

According to the improved concept, also an MRI system is provided. The MRI system comprises gradient coils for generating respective components of a magnetic field gradient along respective coordinate axes of a coil coordinate system, a computing unit and a storage unit. The storage unit stores an orientation of a predefined logical coordinate system with respect to a coil coordinate system and the storage unit stores at least one predefined first limit value concerning the components of the magnetic field gradient in the coil coordinate system. The computing unit is configured to determine, in particular automatically, at least one second limit value concerning respective components of the magnetic field gradient in the logical coordinate system depending on the orientation and on the at least one first limit value. The computing unit is configured to determine, in particular automatically, a gradient sequence for the components of the magnetic field gradient in the logical coordinate system depending on the at least second limit value, in order to implement a predefined k-space sampling scheme. The computing unit is configured to control the magnetic resonance imaging system to carry out a magnetic resonance imaging scan according to the k-space sampling scheme, wherein the gradient coils are controlled to carry out the gradient sequence.

The storage unit may be implemented as a persistent memory or as a dynamic memory, such as a random access memory, RAM. In particular, the orientation of the logical coordinate system with respect to the coil coordinate system may be obtained via a user input interface of the MRI system, which provides the orientation to the storage unit, for example the dynamic memory.

Further implementations of the MRI system according to the improved concept follow directly from the various implementations of the method according to the improved concept and vice versa. In particular, an MRI system according to the improved concept may be configured to carry out a method according to the improved concept or carries out such a method.

According to the improved concept, a computer program comprising instructions is provided. When the computer program or the instructions, respectively, are executed by an MRI system according to the improved concept, the instructions cause the MRI system to carry out a method according to the improved concept.

According to the improved concept, also a computer-readable storage medium is provided, which stores a computer program according to the improved concept.

The computer program as well as the computer-readable storage medium may be considered as respective computer program products comprising the instructions.

The features and feature combinations mentioned above or below in the description of figures and/or shown in the figures alone are usable not only in the respective specified combinations, but also in other combinations without departing from the scope of the invention. Implementations and feature combinations, which do not have all features of an originally formulated independent claims and/or extend beyond or deviate from the feature combinations set out in the relations of the claims, are also to be considered as disclosed.

In the figures

FIG 1     shows schematically an exemplary implementation of an MRI system according to the improved concept;

FIG 2    shows a schematic flow diagram of an exemplary implementation of a method according to the improved concept; and

FIG 3    shows a coil coordinate system and a logical coordinate system.

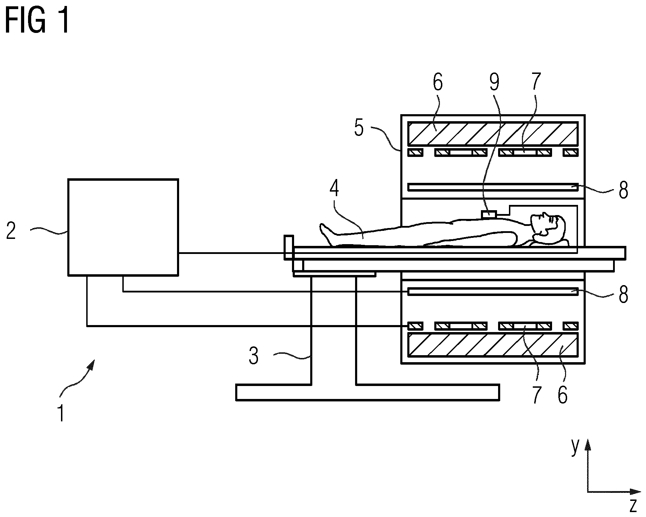

FIG 1 shows a schematic representation of an exemplary implementation of an MRI system 1 according to the improved concept.

The MRI system 1 comprises an MRI scanner 5 with a field magnet 6, which may generate a static magnetic field for aligning the nuclear spins of an object 4 to be imaged. The MRI scanner 5 may comprise a bore comprising an imaging region, wherein the static magnetic field is extremely homogenous with respect to its magnetic field strength or its absolute value within the imaging region. The object 4 may be arranged on a patient table 3, which may be movable to vary the position of the object 4.

The field magnet 6 may for example comprise a superconducting magnet, that is an electromagnet with a superconducting coil. In this way, static magnetic fields up to 3T or above may be achieved. For lower field strengths, also permanent magnets or electromagnets with normal conducting coils may be used.

The MRI scanner 5 further comprises gradient coils 7, which may generate respective variable magnetic fields along each of the three spatial dimensions X, Y, Z and superpose the variable magnetic fields with the basic magnetic field to achieve a spatial encoding. The gradient coils 7 may be coils comprising normal conducting wires. In particular, the gradient coils 7 may comprise one or more coils to generate a magnetic field gradient in the X-direction, one or more coils to generate magnetic field gradients in the Y-direction and one or more gradient coils to generate magnetic field gradients along the Z-direction.

Furthermore, the MRI scanner 5 may comprise one or more sending coils 8 in order to generate RF-pulses for exciting nuclear spins to precess in the respective magnetic field. The sending coils 8 may also operate as receiving coils to receive the MRI signals in response to the nuclear spin excitation and precession resonance. Alternatively or in addition, one or more dedicated receiving coils 9, such as body coils arranged in the immediate environment of the object 4, may be used.

The MRI system 1 further comprises a computing unit 2, which is coupled to the gradient coils 7, the sending coils 8 and the receiving coils 9. The computing unit 2 may determine an MRI acquisition sequence according to a give k-space sampling scheme and control the sending and receiving coils 8, 9, accordingly. In addition, the computing unit 2 determines a gradient sequence to control the gradient coils 7 accordingly for generating a sequence of magnetic field gradients.

In general, the coil axes X, Y, Z do not necessarily correspond to the logical axes read R, phase P and slice S. In particular, the respective angulation of the slice to be imaged by means of the MRI scan is given by a rotation matrix transforming the logical coordinate system R, P, S into the coil coordinate system X, Y, Z:

$$
\begin{matrix}
R_{11} & R_{12} & R_{13} \\
R_{21} & R_{22} & R_{23} \\
R_{31} & R_{32} & R_{33}
\end{matrix}
$$

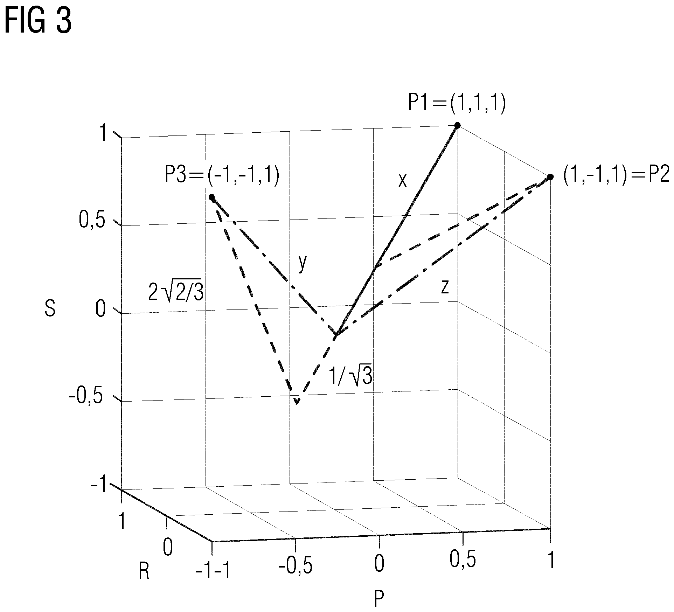

FIG 3 shows exemplarily the logical coordinate system with the read-axis R, the phase-axis P and the slice-axis S, and in addition the coil coordinate system with the coil axes X, Y, Z. Furthermore, three points PI, P2, P3 are shown together with their coordinates in the logical coordinate system R, P, S.

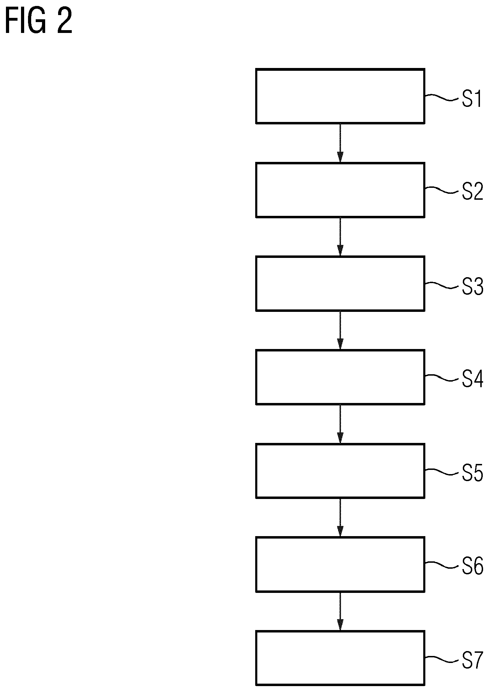

The functionality of the MRI system 1 is described in more detail in the following with respect to an exemplary implementation of a method for operating an MRI system 1 according to the improved concept. FIG 2 shows a corresponding flow diagram for such a method.

In step S1, a user of the MRI system 1 may for example select an angulation of the planned acquisition. A corresponding representation of the respective rotation matrix may be stored on a storage unit of the computing unit 2.

Furthermore, the computing unit 2 receives a limit value for the absolute value of the magnetic field gradients in the coil coordinate system X, Y, Z and, for example, a limit value for the respective slew rates of the magnetic field gradient components in the coil coordinate system X, Y, Z from the storage unit.

In step S2, the computing unit 2 determines a corresponding limit value for the absolute value of the magnetic field gradients in the logical coordinate system R, P, S and, for example, a corresponding limit value for the slew rates of the magnetic field gradient components in the logical coordinate system R, P, S. To determine these limit values, the computing unit 2 takes into account the limit values for the components of the magnetic field gradient in the coil coordinate system X, Y, Z as well as the rotation matrix according to the selected angulation.

In particular, the computing unit 2 may calculate the highest possible gradient values for the logical coordinate system R, P, S. To this end, the computing unit 2 may determine the worst case combination of magnetic field gradients in the logical coordinate system R, P, S along a given coordinate axis X, Y, Z for a given slice orientation and, if applicable, additional information. Then, the computing unit 2 may calculate an angulation specific buffer based on the largest combination to be expected along the coordinate axes.

The additional information may for example be represented by boundary conditions concerning predefined correlations between different components of the magnetic field gradients in the logical coordinate system. The limit values may be expressed as

$$\texttt{L\_l = (L\_c / M), L\_l = (L\_c / M),}$$

wherein L_l corresponds to the respective second limit value for the logical coordinate system, L_c corresponds to the respective first limit value for the coil coordinate system.

If no relationship between different magnetic field gradient polarities and absolute values for the different logical axes is known, M is given by

$$\texttt{M = max|}_{\texttt{ie\{1,2,3\}}}\texttt{(|R}_{\texttt{i1}}\texttt{|+|R}_{\texttt{i2}}\texttt{|+|R}_{\texttt{i3}}\texttt{|).}$$

In case it is known that the slew rate for the magnetic field gradient along the phase-axis P is less than $\alpha$ times the slew rate for the magnetic field gradient along the read-axis R and that the absolute value of the magnetic field gradient along the phase-axis P is less than $\alpha$ times the absolute value of the magnetic field gradient along the read-axis R, wherein for example $0 < \alpha < 1$, M is given by

$$\texttt{M = max|}_{\texttt{ie\{1,2,3\}}}\texttt{(}\alpha\texttt{|R}_{\texttt{i1}}\texttt{|+|R}_{\texttt{i2}}\texttt{|+|R}_{\texttt{i3}}\texttt{|).}$$

When read and slice gradient amplitudes and slew rates are known to have non-opposing polarities, M is given by

$$\texttt{M = max|}_{\texttt{ie\{1,2,3\}}}\texttt{(|R}_{\texttt{i1}}\texttt{|+|R}_{\texttt{i2}}\texttt{+R}_{\texttt{i3}}\texttt{|),}$$

and when read and slice gradient amplitudes and slew rates are known to have non-identical polarities, M is given by

$$\texttt{M = max|}_{\texttt{ie\{1,2,3\}}}\texttt{(|R}_{\texttt{i1}}\texttt{|-|R}_{\texttt{i2}}\texttt{+R}_{\texttt{i3}}\texttt{|).}$$

In step S3, the computing unit 2 may determine a gradient sequence for the components of the magnetic field gradient in the logical coordinate system R, P, S depending on the determined second limit values for the logical coordinate system R, P, S in order to implement a k-space sampling scheme.

To this end, the computing unit 2 may for example calculate the shortest possible echo time TE and repetition time TR between fixed timing events, at which the gradients may not be arbitrarily adapted, such as during read-out or during sending of RF-pulses. Between these events, the shortest possible timing parameters TE, TR may be calculated based on the limitations given by the second limit values for the logical coordinate system R, P, S.

For each coordinate axis X, Y, Z, the shortest possible time to achieve the required gradient moment at the required start and end point may be calculated by applying the highest possible slew rate and gradient amplitude allowed on each coil coordinate axis X, Y, Z.

In an optional step S4, the sequence may be further optimized, for example iteratively or by evaluating the highest gradient usage throughout the sequence. For example, according to GRE sequences or bSSFP sequences, only the polarity of the magnetic field gradient in phase direction P is given by the required k-space lines or spokes that need to be acquired. For slice and read-out axes S, R, however, the gradient polarity is not fixed. Therefore, the logical coordinate system R, P, S may be modified by inverting the slice direction S and/or the read-out direction R. In this way, constructive overlays for magnetic field gradients in the logical coordinate system onto one of the coil axes may be changed into destructive overlays. Therefore, for the slice-axis S, the phase and frequency of the corresponding RF-pulse needs to be inverted so that still the same slice is excited, but all gradients on the slice-axis S have an inverted polarity. For the inversion of the gradients on the read-axis R, the read-out direction of the images needs to be rotated by 180°. Both measures usually do not have an impact on the acquired image in the end, however, for optimizing the gradient usage, they may have a benefit.

Especially in those parts of the sequence, where the worst overlap of the gradients in the logical coordinate system occurs, high slew rates or amplitudes on the coordinate axes X, Y, Z and corresponding high stimulations may be avoided by the inversion of the direction and allow for a significantly reduced gradient activity on the coil coordinate axes X, Y, Z.

In an iterative approach, all possible combinations of read-slice polarities may be tested, and the most beneficial configuration may be selected automatically.

The advantage of toggling gradient signs may be visualized with respect to FIG 3. It is assumed that the same slew rates and amplitude gradients are present in all three coordinate axes X, Y, Z. The point P1 = (1, 1, 1) in the logical coordinate system R, P, S corresponds to (1, 0, 0) in the coil coordinate system X, Y, Z, the point P1 = (1, -1, 1) in R, P, S corresponds to (0, 0, 1) in X, Y, Z and P3 = (-1, -1, 1) corresponds to (0, 1, 0) in X, Y, Z. In this worst case situation, the amplitude and slew rates according to the X axis are increased by factor of $(3)^{1/2}$ with respect to the logical coordinate system. It is further assumed that the read-out gradient and the slice selection gradient have a fixed polarity. The phase encoding gradient changes its polarity during a scan. If the slice or the read gradient is inverted, the resulting values in the worst case are reduced to a factor of $2*(2/3)^{1/2}$.

In step S5, the computing unit determines a corresponding gradient sequence for the components of the magnetic field gradient in the logical coordinate system R, P, S or the modified logical coordinate system depending on the limit values for the logical coordinate system to implement the desired k-space sampling scheme.

In step S6, the computing unit 2 controls the MRI scanner 5 and, in particular, the sending and receiving coils 8, 9 as well as the gradient coils 7 to carry out the MRI scan according to the k-space sampling scheme and the determined gradient sequence.

In step S7, the computing unit 2 may use the received MRI signals to reconstruct an image for the object 4.

As described, in particular with respect to the figures, the improved concept allows for an optimized gradient usage during MRI scans. In particular, the maximum amplitudes for magnetic field gradients and the maximum slew rates for magnetic field gradients may be increased for different orientations of the slice to be imaged. Furthermore, the timing parameters may be minimized accordingly.

Another possible degree of freedom for affecting gradient activity is to omit an echo acquisition at the end or at the beginning of the echo. For example, in case of bSSFP sequences, the beginning of the echo may be omitted, which reduces TE. However, also omitting the end parts of the echo leads to similar results.

According to several implementations, in a first step an optimal gradient amplitude and slew rate limit for an initial slice orientation is calculated and in a second step, a user is allowed to make modifications to the slice orientation in real time during the imaging. In a third step, a new set of gradient amplitude and slew rate limits optimized for the modified slice orientation may be calculated. In a fourth step, either the echo time and repetition time may be minimized based on the new set of gradient amplitude and slew rate limits in order to preserve image quality or other sequence parameters, such as resolution parameters or duration of the slice selective RF-pulse and partial Fourier factor, may be modified in order to preserve the frame rate. Also combinations are possible.

By means of the improved concept, gradient usage and/or timing parameters of MRI sequences may be optimized by considering a requested angulation. To this end, gradient parameters and/or polarities on the different logical axes may be optimized and/or omitted or outer k-space parts may be changed for a symmetric sampling.

Additionally, the approach may be incorporated into real time interactive sequences, in which the slice orientation may be changed during imaging.

## Claims

1. Method for operating a magnetic resonance imaging system (1) comprising gradient coils (7) for generating respective components of a magnetic field gradient along respective coordinate axes of a coil coordinate system (X, Y, Z),
   **characterized in that** the method comprises using a computing unit (2) to

   - receive an orientation of a predefined logical coordinate system (R, P, S) with respect to the coil coordinate system (X, Y, Z);
   - receive at least one predefined first limit value concerning the components of the magnetic field gradient in the coil coordinate system (X, Y, Z);
   - determine at least one second limit value concerning respective components of the magnetic field gradient in the logical coordinate system (R, P, S) depending on the orientation and on the at least one first limit value;
   - determine a gradient sequence for the components of the magnetic field gradient in the logical coordinate system (R, P, S) depending on the at least one second limit value to implement a predefined k-space sampling scheme; and
   - control the magnetic resonance imaging system (1) to carry out a magnetic resonance imaging scan according to the k-space sampling scheme, wherein the gradient coils (7) are controlled to carry out the gradient sequence.

**2.** Method according to claim 1,
**characterized in that**

- the at least one first limit value comprises a first maximum absolute value for an amplitude of the components of the magnetic field gradient in the coil coordinate system (X, Y, Z); and
- the at least one second limit value comprises a second maximum absolute value for the amplitude of the components of the magnetic field gradient in the logical coordinate system (R, P, S).

**3.** Method according to one of the preceding claims,
**characterized in that**

- the at least one first limit value comprises a first maximum absolute value for a slew rate of the components of the magnetic field gradient in the coil coordinate system (X, Y, Z); and
- the at least one second limit value comprises a second maximum absolute value for a slew rate of the components of the magnetic field gradient in the logical coordinate system (R, P, S).

**4.** Method according to one of the preceding claims,
**characterized in that**

- the computing unit (2) is used to receive at least one boundary condition for the gradient sequence; and
- the at least one second limit value is determined depending on the at least one boundary condition.

**5.** Method according to claim 4,
**characterized in that**
the at least one boundary condition comprises at least one predefined correlation between the components of the magnetic field gradient in the logical coordinate system (R, P, S).

**6.** Method according to claim 4,
**characterized in that**
the at least one boundary condition comprises

- at least one predefined correlation between respective polarities of the components of the magnetic field gradient in the logical coordinate system (R, P, S); and/or
- at least one predefined correlation between respective absolute values of amplitudes of the components of the magnetic field gradient in the logical coordinate system (R, P, S).

**7.** Method according to one of the preceding claims,
**characterized in that**

- the orientation of the logical coordinate system (R, P, S) with respect to the coil coordinate system (X, Y, Z) is given by a set of rotation parameters; and
- the at least one second limit value is determined depending on the set of rotation parameters.

**8.** Method according to one of the preceding claims
**characterized in that**
for determining the gradient sequence, at least one timing parameter of the magnetic resonance imaging scan is minimized, wherein the at least one second limit value is used as at least one minimization boundary condition.

**9.** Method according to claim 8,
**characterized in that**
the at least one timing parameter comprises an echo time and/or a repetition time.

**10.** Method according to one of the preceding claims,
**characterized in that**
the logical coordinate system (R, P, S) comprises

- a read-axis (R) corresponding to a frequency encoded spatial direction; and/or
- a phase-axis (P) corresponding to a phase encoded spatial direction; and/or

- a slice-axis (S) corresponding to a spatial direction, which is perpendicular to a slice to be imaged.

11. Method according to one of the preceding claims,
   **characterized in that**

   - the computing unit (2) is used to compute a modified orientation of a modified logical coordinate system;
   - a direction of a modified coordinate axis of the modified logical coordinate system is opposite to a direction of a coordinate axis of the predefined logical coordinate system (R, P, S); and
   - the at least one second limit value is determined depending on the modified orientation.

12. Method according to one of the preceding claims
   **characterized in that**

   - the gradient sequence is determined as a gradient sequence for a gradient echo pulse sequence; or
   - the gradient sequence is determined as a gradient sequence for a balanced steady-state free precession pulse sequence.

13. Magnetic resonance imaging system comprising gradient coils (7) for generating respective components of a magnetic field gradient along respective coordinate axes of a coil coordinate system (X, Y, Z),
   **characterized in that** the magnetic resonance imaging system comprises

   - a storage unit storing an orientation of a predefined logical coordinate system (R, P, S) with respect to the coil coordinate system (X, Y, Z) and at least one predefined first limit value concerning the components of the magnetic field gradient in the coil coordinate system (X, Y, Z); and

   a computing unit (2), which is configured to

   - determine at least one second limit value concerning respective components of the magnetic field gradient in the logical coordinate system (R, P, S) depending on the orientation and on the least one first limit value;
   - determine a gradient sequence for the components of the magnetic field gradient in the logical coordinate system (R, P, S) depending on the at least one second limit value to implement a predefined k-space sampling scheme; and
   - control the magnetic resonance imaging system (1) to carry out a magnetic resonance imaging scan according to the k-space sampling scheme, wherein the gradient coils (7) are controlled to carry out the gradient sequence.

14. Computer program product comprising instructions, which, when executed by a magnetic resonance imaging system (1) according to claim 13, cause the magnetic resonance imaging system (1) to carry out a method according to one of claims 1 to 12.

FIG 1

FIG 2

FIG 3

Europäisches
Patentamt

European
Patent Office

Office européen
des brevets

# EUROPEAN SEARCH REPORT

Application Number

EP 20 21 2205

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BERNSTEIN MATT A. ET AL: "Angle-dependent utilization of gradient hardware for oblique MR imaging", JOURNAL OF MAGNETIC RESONANCE IMAGING, vol. 4, no. 1, 1 January 1994 (1994-01-01), pages 105-108, XP055801534, US ISSN: 1053-1807, DOI: 10.1002/jmri.1880040121 * abstract, section "METHODS"; figure 1 * | 1-14 | INV. G01R33/385 G01R33/48 G01R33/54 G01R33/483 ADD. G01R33/561 |
| X | US 5 399 969 A (BERNSTEIN MATTHEW A [US]) 21 March 1995 (1995-03-21) * the whole document * | 1-14 | |
| X,D | US 2020/064426 A1 (ERSOZ ALI [US]) 27 February 2020 (2020-02-27) * paragraph [0086] - paragraph [0095]; figures 4,21 * | 1-14 | |

TECHNICAL FIELDS
SEARCHED      (IPC)

G01R

The present search report has been drawn up for all claims

| Place of search | Date of completion of the search | Examiner |
|---|---|---|
| Munich | 6 May 2021 | Lebar, Andrija |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**EP 4 009 066 A1**

**ANNEX TO THE EUROPEAN SEARCH REPORT
ON EUROPEAN PATENT APPLICATION NO.**

EP 20 21 2205

06-05-2021

| Patent document cited in search report | | Publication date | Patent family member(s) | | Publication date |
|---|---|---|---|---|---|
| US 5399969 | A | 21-03-1995 | DE 4426773 | A1 | 09-02-1995 |
| | | | JP 3499922 | B2 | 23-02-2004 |
| | | | JP H07148138 | A | 13-06-1995 |
| | | | US 5399969 | A | 21-03-1995 |
| US 2020064426 | A1 | 27-02-2020 | CN 110857972 | A | 03-03-2020 |
| | | | US 2020064426 | A1 | 27-02-2020 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200064426 A1